# EUROPÄISCHE PATENTSCHRIFT

(11) **EP 1 373 162 B1**
(45) Veröffentlichungstag und Bekanntmachung des Hinweises auf die Patenterteilung: **21.12.2005**
(21) Anmeldenummer: 02722008.6
(22) Anmeldetag: 11.03.2002
(51) Int. Cl.: C04B 35/58, H01L 39/24, H01L 39/12, C04B 35/65

(54) **PULVER AUF MAGNESIUMDIBORID-BASIS FÜR DIE HERSTELLUNG VON SUPRALEITERN, VERFAHREN ZU DESSEN HERSTELLUNG UND ANWENDUNG**
MGB 2? BASED POWDER FOR THE PRODUCTION OF SUPER CONDUCTORS, METHOD FOR THE USE AND PRODUCTION THEREOF
POUDRE A BASE DE MGB 2? DESTINEE A LA PRODUCTION DE SUPRACONDUCTEURS, PROCEDE DE FABRICATION DE CETTE POUDRE ET UTILISATION

(30) Priorität: 12.03.2001 DE 10112457
(43) Veröffentlichungstag der Anmeldung: 02.01.2004
(73) Patentinhaber: Leibniz-Institut für Festkörper- und Werkstoffforschung Dresden e.V., 01069 Dresden (DE)
(72) Erfinder: GÜMBEL, Andreas, 01099 Dresden (DE); ECKERT, Jürgen, 01139 Dresden (DE); SCHULTZ, Ludwig, 01474 Dresden (DE); BARTUSCH, Birgit, 01237 Dresden (DE)
(74) Vertreter: Rauschenbach, Dieter
(86) Internationale Anmeldenummer: PCT/DE2002/000905
(87) Internationale Veröffentlichungsnummer: WO 2002/072501

(56) Entgegenhaltungen:
- WO-A-02/069353
- NAGAMATSU J ET AL: "SUPERCONDUCTIVITY AT 39 K IN MAGNESIUM DIBORIDE" NATURE, MACMILLAN JOURNALS LTD. LONDON, GB, Bd. 410, 1. März 2001 (2001-03-01), Seiten 63-64, XP002948368 ISSN: 0028-0836 in der Anmeldung erwähnt

## Beschreibung

### Technisches Gebiet

Die Erfindung betrifft ein Pulver auf MgB₂-Basis zur Herstellung von Supraleitern, Verfahren zu dessen Herstellung und Anwendung.

### Stand der Technik

Es ist bereits bekannt, dass die binäre Legierung MgB₂ im Temperaturbereich von T_{c} = 38 K bis 40 K supraleitend ist (J.Nagamatsu et al., Nature vol. 410 (2001), 63-64). Hierbei wurde eine Pulvermischung, bestehend aus Mg-Pulver und B-Pulver, zunächst kaltverpresst. Diese Formkörper wurden anschließend durch heissisostatisches Pressen oder Sintern zu Massivkörpern weiterverarbeitet.

Nachteilig bei diesem Verfahren ist, dass zum heissisostatischen Pressen hohe Drücke notwendig sind um dichte Proben zu erhalten und das Abdampfen von Mg zu verhindern, wodurch es zu einer Stöchiometrieverschiebung und ungünstigen supraleitenden Eigenschaften kommt. Auch kommt es beim Sintern konventioneller Pulver zu einer starken Volumenzunahme bei der Phasenbildung, und daher zu Rissen im Massivkörper. Beim Sintern wird weiterhin die Korngröße wesentlich durch die Wahl der Wärmebehandlung bestimmt, wobei sich nur Körner der gewünschten Phase mit Mikrometergröße und niedrigen kritischen Strömen bilden lassen. Die gesinterten Proben sind meist sehr spröde und besitzen nur eine geringe Dichte.

Es wurde auch schon ein supraleitender MgB₂-Draht hergestellt, indem in einer Quarzampulle ein Bor-Draht bei Anwesenheit von Mg-Pulver wärmebehandelt wurde, wobei Mg in den Bor-Draht eindiffundiert (Canfield et al. Superconductivity in dense MgB₂ wires, Cond. Mat., to be publ. cond-mat Homepage vom 15.02.01: cond-mat/0102289). Eine derartige Verfahrensweise ist für die Herstellung von technischen Supraleitern jedoch nicht geeignet.

### Darstellung der Erfindung

Der Erfindung liegt die Aufgabe zugrunde, ein Pulver auf MgB₂-Basis zur Herstellung von Supraleitern zu schaffen, das eine hohe Reaktivität aufweist, so dass es bei deutlich niedrigeren Temperaturen gesintert und zu massiven Proben mit hoher Dichte, einer hohen supraleitenden Sprungtemperatur und einem hohen kritischen Strom kompaktiert werden kann.

Diese Aufgabe wird dadurch gelöst, dass das Pulver ein mechanisch legiertes Pulver ist, dessen Pulverteilchen eine mittlere Teilchengröße von d < 250 µm und eine Substruktur, bestehend aus nanokristallinen Körnern in den Abmessungen < 100 nm, besitzen.

Dabei können gemäß einer vorteilhaften Ausgestaltung der Erfindung im Kristallgitter der Pulverteilchen die chemischen Elemente H, Li, Na, Be, Mg, B, Ca, Sr, Ba, Al, Ga, In, Tl, C, Si, Ge, Sn, Pb, N, O, P, As, Sb, Bi, F, Cl, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os und/oder Ru enthalten sein.

Zur Herstellung des erfindungsgemäßen Pulvers wird eine Pulvermischung, bestehend aus Mg-Pulverteilchen und B-Pulverteilchen, bis zum Erreichen einer mittleren Teilchengröße von d < 250 µm und der Bildung einer Pulverteilchensubstruktur, bestehend aus nanokristallinen Körnern in den Abmessungen < 100 nm, mittels mechanischem Legieren zerkleinert.

Zur Herstellung des oben genannten MgB₂-Pulvers, bei dem im Kristallgitter weitere chemische Elemente enthalten sein sollen, werden Mg-Pulverteilchen und Bor-Pulverteilchen mit einem Zusatz von bis zu 20 Atomprozent Pulverteilchen der chemischen Elemente Li, Na, Be, Mg, Ca, Sr, Ba, Al, Ga, In, Tl, C, Si, Ge, Sn, Pb, P, As, Sb, Bi, La, Ce, Pr, Nd, Pm, Sm, Eu, Gd, Tb, Dy, Ho, Er, Tm, Yb, Lu, Th, Ag, Cu, Au, Ni, Co, Pd, Pt, *Sc, Y,* Hf, Ti, Zr, Ta, V, Nb, Cr, Mo, Mn, Os und/oder Ru und/oder Pulverteilchen von Oxiden, Karbiden, Nitriden und/oder deren Mischkristalle bis zum Erreichen einer mittleren Teilchengröße von d < 250 µm und der Bildung einer Pulverteilchensubstruktur, bestehend aus nanokristallinen Körnern in den Abmessungen < 100 nm, mittels mechanischem Legieren zerkleinert.

Das mechanische Legieren kann unter Schutzgas oder in Luft und/oder unter Anwesenheit der gasförmigen Elemente H, N, O und/oder F durchgeführt werden.

Nach dem mechanischen Legieren wird im Falle des Vorliegens eines nur partiell legierten Pulvers das Pulver einer Wärmebehandlung unterworfen.

Für die Wärmebehandlung wird eine Temperatur gewählt, die mindestens 200 K unterhalb der typischen Reaktionstemperatur herkömmlicher Pulver dieser Art mit Pulverteilchen mit einer Größe im Mikrometermaßstab liegt.

Das Pulver wird in vollständig oder nur partiell legierter Ausführung zur Herstellung von hochtemperatursupraleitenden Massivkörpern verwendet, wobei das Pulver zu Massivkörpern verpresst und diese danach gesintert werden. Dabei wird beim Verpressen im Falle des Einsatzes eines nur partiell legierten Pulvers die Temperatur mindestens 200 K unterhalb der typischen Reaktionstemperatur herkömmlicher Pulver dieser Art mit Pulverteilchen mit einer Größe im Mikrometermaßstab gewählt.

Das Pulver kann auch in vorteilhafter Weise in vollständig oder nur partiell legierter Ausführung als Ausgangspulver für die Pulver-im-Rohr-Technologie zur Herstellung von hochtemperatursupraleitenden Drähten und Bändern eingesetzt werden. Dabei wird im Falle des Einsatzes eines nur partiell legierten Pulvers die im Herstellungsprozess übliche Wärmebehandlung zur Bildung der supraleitenden Phase bei einer Temperatur durchgeführt, die mindestens 200 K unterhalb der typischen Reaktionstemperatur herkömmlicher Pulver dieser Art mit Pulverteilchen mit einer Größe im Mikrometermaßstab liegt.

Die Wärmehandlung beziehungsweise das Verpressen werden im Rahmen des erfindungsgemäßen Verfahrens zweckmäßig bei Temperaturen zwischen 300°C und 900°C durchgeführt.

Eingeschlossen in die Erfindung ist die Verwendung des erfindungsgemäßen Pulvers oder der daraus hergestellten Massivkörper als Ausgangs- oder Einsatzmaterial zur Herstellung von Einkristallen, Drähten und Bändern oder als Targetmaterial bei der Abscheidung von Schichten.

Die Erfindung zeichnet sich durch folgende wesentliche Vorteile aus:

Erfindungsgemäß erfolgt die Phasenbildung entweder vollständig als Festkörperreaktion bei tiefen Temperaturen oder durch das Anlassen von nanokristallinem Sekundärpulver, das wesentlich reaktiver ist, als kommerziell erhältliches Element- und MgB₂-Pulver.

Vorteilhaft ist, dass bei der Herstellung des erfindungsgemäßen Pulvers kein selektives Abdampfen der Einzelkomponenten erfolgt und dass die Stöchiometrie sowie der Volumenanteil von reagierter Phase mit AlB₂-Struktur lassen sich exakt einstellen lassen.

Das erfindungsgemäße Pulver ermöglicht eine einzigartige nanokristalline Mikrostruktur, vergleichbar mit der von Schichten.

Die Phasenbildung in partiell reagiertem Pulver kann durch zusätzliches Tempern bei Temperaturen deutlich unterhalb der beim Stand der Technik angewandten Temperaturen erfolgen.

Das Pulver und die daraus herstellbaren supraleitenden Massivkörper weisen bei vergleichbarer supraleitender Übergangstemperatur von T_{c} ~ 39 K eine bessere Probenhomogenität auf.

Die erfindungsgemäß hergestellten Massivkörper sind einfach herstellbar und besitzen im Vergleich zu Sinterproben eine höhere Dichte von ca. 85% bis 90% und sind weniger spröde. Sie lassen sich problemlos schleifen, polieren oder sägen.

Die so hergestellten Massivkörper weisen auch ein besseres Pinningverhalten auf und besitzen eine bessere Stromtragfähigkeit.

Bei den erfindungsgemäß hergestellten Massivkörpern wird im Vergleich zu konventionellen gesinterten Massivproben in vorteilhafter Weise eine Verschiebung der Irreversibilitätslinie Hᵢᵣᵣ zu höheren Magnetfeldern erreicht, vor allem bei niedrigeren Temperaturen, bei vergleichbarem H_{c2}.Die starke Verschiebung von Hᵢᵣᵣ zu höheren Magnetfeldern resultiert in einer geringeren Separation von Hᵢᵣᵣ und H_{c2} und führt zu einem stärkeren Pinningverhalten, das wesentlich besser ist, als bei konventionellen Massivproben und im Bereich dünner Schichten mit c-Achsen Texturierung.

Das erfindungsgemäße Pulver lässt sich auch sehr gut für die Pulver-im-Rohr-Technologie einsetzen und ermöglicht dabei gute Umformbedingungen beim Strangpressen und Drahtziehen.

### Wege zur Ausführung der Erfindung

Die Erfindung ist nachstehend an Hand von Ausführungsbeispielen näher erläutert.

### Beispiel 1

Handelsübliches kristallines Mg- und amorphes Borpulver mit Teilchengrößen von einigen µm werden unter Ar-Schutzgas in einem Wolframkarbid-Mahlbecher mit einem Volumen von 250 ml in einem Verhältnis von 1:2 (Atom-%) gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 20 h durchgeführt. Am Ende des Mahlvorgangs liegt ein Sekundärpulver vor, das aus verschiedenen nanokristallinen und amorphen Phasen besteht. Bei Strukturuntersuchungen mittels Röntgendiffraktometrie wurde ersichtlich, dass die Pulvermischung näherungsweise folgende Zusammensetzung aufweist:
1. nanokristallines Mg
2. nanokristallines MgB₂
3. amorphes Bor (unreagiertes Ausgangspulver), allerdings nur als amorpher Untergrund erkennbar
4. nanokristallines Wolframkarbid vom Mahlabrieb, Volumenanteil in der Größenordnung 1%.

Der Volumenanteil von Mg ist etwa 3 mal so hoch wie der Volumenanteil von MgB₂.

Das erhaltene Pulver wurde anschließend in einem Kalorimeter mit einer Heizrate von 20 K/min auf 1173 K geheizt und diese Temperatur 10 min. gehalten. Dabei war eine starke exotherme Reaktion erkennbar, die von der Bildung der MgB₂-Phase verursacht wird und bereits unterhalb von 973 K abgeschlossen ist. Die komplette Umwandlung in die MgB₂-Phase wurde bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines MgB₂. Der Phasenanteil von MgB₂ liegt im Bereich von >96 vol.%. Daneben liegen etwa 3 vol.% MgO und WC-Mahlabrieb in der Größenordnung von etwa 1 vol.% vor.

Die erzielte Dichte beträgt ca. 85% der theoretischen Dichte von MgB₂. Die Korngröße der supraleitenden MgB₂-Phase liegt im Bereich von 40 nm bis 100 nm. Die supraleitende Sprungtemperatur beträgt ca. 34,5 K bis 37 K. Das Massivmaterial weist eine kritische Stromdichte von ca. 10⁵ A/cm² bei 20 K und 1 Tesla auf und die Irreversibilitätslinie Hᵢᵣᵣ(T) ist in Richtung höherer Felder verschoben, d.h. Hᵢᵣᵣ(T) ~ 0,8 H_{c2}(T) im Gegensatz zu typischerweise Hᵢᵣᵣ(T) ~ 0,5 H_{c2}(T) für konventionelle, untexturierte, gesinterte Massivproben.

### Beispiel 2

Handelsübliches kristallines Mg- und amorphes Borpulver mit Teilchengrößen von einigen µm werden unter Ar-Schutzgas in einem Wolframkarbid-Mahlbecher mit einem Volumen von 250 ml in einem Verhältnis von 1:2 (Atom-%) gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 50 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wird ersichtlich, daß die Pulvermischung näherungsweise folgende Zusammensetzung aufweist:
1. nanokristallines Mg
2. nanokristallines MgB₂
3. amorphes Bor (unreagiertes Ausgangspulver), allerdings nur als amorpher Untergrund erkennbar
4. nanokristallines Wolframkarbid vom Mahlabrieb, Volumenanteil in der Größenordnung 1%.
Der Volumenanteil von Mg ist im Vergleich zur geringeren Mahldauer deutlich niedriger, der Anteil von MgB₂ deutlich höher.
   Das erhaltene Pulver wird anschließend in einem Kalorimeter mit einer Heizrate von 20 K/min auf 1173 K geheizt und diese Temperatur 10 min. gehalten. Deutlich erkennbar ist auch hier eine exotherme Reaktion, die von der Bildung der MgB₂-Phase verursacht wird und bereits unterhalb von 873 K abgeschlossen ist. Da im unbehandelten Sekundärpulver bereits ein höherer Volumenanteil der MgB₂-Phase vorliegt, ist die freiwerdende Energiemenge allerdings wesentlich geringer als bei Sekundärpulver nach 20 h Mahldauer. Die komplette Umwandlung in die MgB₂-Phase wurde bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines MgB₂. Der Phasenanteil von MgB₂ liegt im Bereich von > 97 vol.%. Daneben liegen etwa 2 vol.% MgO und etwa 1 vol.% WC-Mahlabrieb vor.

Die erzielte Dichte beträgt ca. 90% der theoretischen Dichte von MgB₂. Die Korngröße der supraleitenden MgB₂-Phase liegt im Bereich von 40 nm bis 100 nm. Die supraleitende Sprungtemperatur beträgt ca. 30 K bis 34,5 K. Das Massivmaterial weist eine kritische Stromdichte von ca. 10⁵ A/cm² bei 20 K und 1 T auf und die Irreversibilitätslinie ist in Richtung höherer Felder verschoben, d.h. Hᵢᵣᵣ(T) ~ 0,8 H_{c2}(T) im Gegensatz zu typischerweise Hᵢᵣᵣ(T) ~ 0,5 H_{c2}(T) für konventionelle, untexturierte, gesinterte Massivproben.

### Beispiel 3

Handelsübliches kristallines Mg- und amorphes Borpulver mit Teilchengrößen von einigen µm werden unter Ar-Schutzgas in einem Wolframkarbid-Mahlbecher mit einem Volumen von 250 ml in einem Verhältnis von 1:2 (Atom-%) gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 100 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wird ersichtlich, daß die Pulvermischung näherungsweise folgende Zusammensetzung aufweist:
1. nanokristallines MgB₂
2. nanokristallines Wolframkarbid vom Mahlabrieb, Volumenanteil in der Größenordnung 1%

Der Volumenanteil von MgB₂ beträgt näherungsweise 98 %. Daneben liegen etwa 1 vol.% MgO und etwa 1 vol.% WC-Mahlabrieb vor.

Das erhaltene Pulver wurde anschließend in einem Kalorimeter mit einer Heizrate von 20 K/min auf 1173 K geheizt und diese Temperatur 10 min. gehalten. Im Gegensatz zu den Sekundärpulvern, die 20 h und 50 h gemahlen wurden, war hier kein deutlicher Reaktionspeak erkennbar. Die vollständige Bildung der MgB₂-Phase erfolgte also bereits im Mahlbecher.

Zur Herstellung von massiven Formkörpern wird das unbehandelte Sekundärpulver mit einem Druck von 640 MPa bei einer Temperatur von 973 K verpreßt. Temperatur und Druck werden dabei für 10 min. gehalten. Die erzielte Dichte ist deutlich niedriger als bei den Beispielen 1 und 2 und beträgt ca. 60% der theoretischen Dichte von MgB₂. Allerdings ist auch diese Probe nahezu phasenrein. Die Korngröße der supraleitenden MgB₂-Phase liegt im Bereich von 40 nm bis 100 nm. Die supraleitende Sprungtemperatur beträgt ca. 30 K bis 34,5 K. Das Massivmaterial weist eine kritische Stromdichte von ca. 10⁵ A/cm² bei 20 K und 1 Tesla auf und die Irreversibilitätslinie ist in Richtung höherer Felder verschoben, d.h. Hᵢᵣᵣ (T) ~ 0,8 H_{c2}(T) im Gegensatz zu typischerweise Hᵢᵣᵣ (T) ~ 0, 5 H_{c2} (T) für konventionelle, untexturierte, gesinterte Massivproben.

### Beispiel 4

Handelsübliches kristallines Mg-, kristallines Si- und amorphes Borpulver mit Teilchengrößen von einigen µm werden unter Ar-Schutzgas in einem Wolframkarbid-Mahlbecher mit einem Volumen von 250 ml in einem Verhältnis von (Mg₁₀₀₋ₓSiₓ; 0 < x < 10) 1:2 (B) (Atom-%) gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 20 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wurde ersichtlich, dass die Pulvermischung näherungsweise folgende Zusammensetzung aufweist:
1.nanokristallines Mg und Si
2.Spuren von Mg(Si)
3. nanokristallines Mg₁₀₀₋ₓSiₓB₂
4.amorphes Bor (unreagiertes Ausgangspulver), allerdings nur als amorpher Untergrund erkennbar
5. nanokristallines Wolframkarbid vom Mahlabrieb, Volumenanteil in der Größenordnung 1 %.

Der Volumenanteil von Mg, Si und Mg(Si) ist etwa 3 mal so hoch wie der Volumenanteil von Mg₁₀₀₋ₓSiₓB₂.

Das erhaltene Pulver wird anschließend in einem Kalorimeter mit einer Heizrate von 20 K/min auf 1173 K geheizt und diese Temperatur 10 min. gehalten. Deutlich erkennbar war eine starke exotherme Reaktion, die von der Bildung der Mg₁₀₀₋ₓSiₓB₂-Phase verursacht wird und bereits unterhalb von 973 K abgeschlossen ist. Die komplette Umwandlung in die Mg₁₀₀₋ₓSiₓB₂-Phase wird bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines Mg₁₀₀₋ₓSiₓB₂. Der Phasenanteil von Mg₁₀₀₋ₓSiₓB₂ liegt im Bereich von > 96 vol. % . Daneben liegen etwa 3 vol.% MgO und etwa 1 vol.% WC-Mahlabrieb vor.

Die erzielte Dichte beträgt ca. 85 % der theoretischen Dichte von Mg₁₀₀₋ₓSiₓB₂. Die Korngröße der supraleitenden MgB₂-Phase liegt im Bereich von 40 nm bis 100 nm. Die supraleitende Sprungtemperatur beträgt ca. 34 K bis 38 K. Das Massivmaterial weist eine kritische Stromdichte von ca. 10⁵ A/cm² bei 20 K und 1 Tesla auf und die Irreversibilitätslinie ist in Richtung höherer Felder verschoben, d.h. Hᵢᵣᵣ(T) ~ 0,8 H_{c2}(T) im Gegensatz zu typischerweise Hᵢᵣᵣ (T) ~ 0,5 H_{c2}(T) für konventionelle, untexturierte, gesinterte Massivproben.

### Beispiel 5

Handelsübliches kristallines Mg-, kristallines Fe- und amorphes Borpulver mit Teilchengrößen von einigen µm werden unter Ar-Schutzgas in einem Wolframkarbid-Mahlbecher mit einem Volumen von 250 ml in einem Verhältnis von (Mg₁₀₀₋ₓFeₓ; 0 < x < 5) 1:2 (B) (Atom-%) gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 20 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wurde ersichtlich, dass die Pulvermischung näherungsweise folgende Zusammensetzung aufweist:
1.nanokristallines Mg Fe
2.Spuren von Mg(Fe)
3.nanokristallines Mg₁₀₀₋ₓFeₓB₂
4.amorphes Bor (unreagiertes Ausgangspulver), allerdings nur als amorpher Untergrund erkennbar
6. nanokristallines Wolframkarbid vom Mahlabrieb, Volumenanteil in der Größenordnung 1%.

Der Volumenanteil von Mg, Fe und Mg(Fe) ist etwa 3 mal so hoch wie der Volumenanteil von Mg₁₀₀₋ₓFeₓB₂.

Das erhaltene Pulver wurde anschließend in einem Kalorimeter mit einer Heizrate von 20 K/min auf 1173 K geheizt und diese Temperatur 10 min. gehalten. Deutlich erkennbar war dabei eine starke exotherme Reaktion, die von der Bildung der Mg₁₀₀₋ₓFeₓB₂-Phase verursacht wird und bereits unterhalb von 973 K abgeschlossen ist. Die komplette Umwandlung in die Mg₁₀₀₋ₓFeₓB₂-Phase wurde bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines Mg₁₀₀₋ₓFeₓB₂. Der Phasenanteil von Mg₁₀₀₋ₓFeₓB₂ liegt im Bereich von > 96 vol.%. Daneben liegen etwa 3 vol.% MgO und etwa 0,3 vol.% WC-Mahlabrieb vor.

Die erzielte Dichte beträgt ca. 85 % der theoretischen Dichte von Mg₁₀₀₋ₓFeₓB₂. Die Korngröße der supraleitenden Mg₁₀₀₋ₓFeₓB₂-Phase liegt im Bereich von 40 nm bis 100 nm. Die supraleitende Sprungtemperatur beträgt ca. 30 K bis 35 K. Das Massivmaterial weist eine kritische Stromdichte von ca. 10⁵ A/cm² bei 20 K und 1 Tesla auf und die Irreversibilitätslinie ist in Richtung höherer Felder verschoben, d.h. Hᵢᵣᵣ(T) ~ 0,8 H_{c2}(T) im Gegensatz zu typischerweise Hᵢᵣᵣ (T) ~ 0,5 H_{c2} (T) für konventionelle, untexturierte, gesinterte Massivproben.

### Beispiel 6

Handelsübliches kristallines Mg-, kristallines Cu- und amorphes Borpulver mit Teilchengrößen von einigen µm werden unter Ar-Schutzgas in einem Wolframkarbid-Mahlbecher mit einem Volumen von 250 ml in einem Verhältnis von (Mg₁₀₀₋ₓCuₓ; 0 < x < 2) 1:2 (B) (Atom-%.) gemischt und in einer Planetenkugelmühle gemahlen. Der Mahlvorgang erfolgt unter der Verwendung von 45 WC-Mahlkugeln (Ø = 10 mm), das Masseverhältnis von Kugeln zu Pulver beträgt 36 und die Geschwindigkeit der Planetenkugelmühle ist 250 U/min. Der Mahlvorgang wird für die Dauer von 20 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wurde ersichtlich, dass die Pulvermischung näherungsweise folgende Zusammensetzung aufweist:
1.nanokristallines Mg und Cu
2.Spuren von Mg (Cu)
3.nanokristallines Mg₁₀₀₋ₓCuₓB₂
4.amorphes Bor (unreagiertes Ausgangspulver), allerdings nur als amorpher Untergrund erkennbar
7. nanokristallines Wolframkarbid vom Mahlabrieb, Volumenanteil in der Größenordnung 1%.

Der Volumenanteil von Mg, Cu und Mg(Cu) ist etwa 3 mal so hoch wie der Volumenanteil von Mg₁₀₀₋ₓCuₓB₂.

Das erhaltene Pulver wurde anschließend in einem Kalorimeter mit einer Heizrate von 20 K/min auf 1173 K geheizt und diese Temperatur 10 min. gehalten. Deutlich erkennbar war dabei eine starke exotherme Reaktion, die von der Bildung der Mg₁₀₀₋ₓCuₓB₂-Phase verursacht wird und bereits unterhalb von 973 K abgeschlossen ist.

Die komplette Umwandlung in die Mg₁₀₀₋ₓCuₓB₂-Phase wurde bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines Mg₁₀₀₋ₓCuₓB₂. Der Phasenanteil von Mg₁₀₀₋ₓCuₓB₂ liegt im Bereich von > 96 vol.%. Daneben liegen etwa 3 vol.% MgO und etwa 0,3 vol.% WC-Mahlabrieb vor.

Die erzielte Dichte beträgt ca. 85% der theoretischen Dichte von Mg₁₀₀₋ₓCuₓB₂. Die Korngröße der supraleitenden MgB₂-Phase liegt im Bereich von 40 nm bis 100 nm. Die supraleitende Sprungtemperatur beträgt ca. 30 K bis 35 K. Das Massivmaterial weist eine kritische Stromdichte von ca. 10⁵ A/cm² bei 20 K und 1 Tesla auf und die Irreversibilitätslinie ist in Richtung höherer Felder verschoben, d.h. Hᵢᵣᵣ(T) ~ 0,8 H_{c2}(T) im Gegensatz zu typischerweise Hᵢᵣᵣ(T) ~ 0,5 H_{c2}(T) für konventionelle, untexturierte, gesinterte Massivproben.

### Beispiel 7

Handelsübliches kristallines Mg-, kristallines Si-, kristallines Fe- und amorphes Borpulver mit Teilchengrößen von einigen µm werden unter Ar-Schutzgas in einem Wolframkarbid-Mahlbecher mit einem Volumen von 250 ml in einem Verhältnis von (Mg_{100-x-y}SiₓFe_{y}B₂; 0 < x < 5; 0 < y 5) 1:2 (B) in Atom-% gemischt und in einer Planetenkugelmühle gemahlen. Der Mahlvorgang erfolgt unter der Verwendung von 45 WC-Mahlkugeln (⌀ = 10 mm), das Masseverhältnis von Kugeln zu Pulver beträgt 36 und die Geschwindigkeit der Planetenkugelmühle ist 250 U/min. Der Mahlvorgang wird für die Dauer von 20 h durchgeführt. Am Ende des Mahlvorgangs liegt ein Sekundärpulver vor, das aus verschiedenen nanokristallinen und amorphen Phasen besteht.

Aus Strukturuntersuchungen mittels Röntgendiffraktometrie wurde ersichtlich, dass die Pulvermischung näherungsweise folgende Zusammensetzung aufweist:
1.nanokristallines Mg, Si und Fe
2.Spuren von Mg(SiFe)
3. nanokristallines Mg_{100-x-y}SiₓFe_{y}B₂
4.amorphes Bor (unreagiertes Ausgangspulver), allerdings nur als amorpher Untergrund erkennbar
8. nanokristallines Wolframkarbid vom Mahlabrieb mit einem Volumenanteil in der Größenordnung 1 %.

Der Volumenanteil von Mg, Si, Fe und Mg(SiFe) ist etwa 3 mal so hoch wie der Volumenanteil von Mg_{100-x-y}SiₓFe_{y}B₂.

Das erhaltene Pulver wurde anschließend in einem Kalorimeter mit einer Heizrate von 20 K/min auf 1173 K geheizt und diese Temperatur 10 min. gehalten. Deutlich erkennbar war dabei eine starke exotherme Reaktion, die von der Bildung der Mg_{100-x-y}SiₓFe_{y}B₂-Phase verursacht wird und bereits unterhalb von 973 K abgeschlossen ist.

Die komplette Umwandlung in die Mg_{100-x-y}SiₓFe_{y}B₂-Phase wurde bestätigt durch Röntgendiffraktometrie nach der Wärmebehandlung.

Zur Herstellung von massiven Formkörpern wird das unbehandelte Sekundärpulver mit einem Druck von 640 MPa bei einer Temperatur von 973 K oder einem Druck von 760 MPa und einer Temperatur von 853 K verpreßt. Temperatur und Druck werden dabei jeweils für 10 min. gehalten. Auch dabei entsteht nahezu phasenreines Mg_{100-x-y}SiₓFe_{y}B₂. Der Phasenanteil von Mg_{100-x-y}SiₓFe_{y}B₂ liegt im Bereich von > 96 vol.%. Daneben liegen etwa 3 vol.% MgO und etwa 0,3 vol.% WC-Mahlabrieb vor.

Die erzielte Dichte beträgt ca. 85 % der theoretischen Dichte von Mg₁₀₀₋ₓCaₓB₂. Die Korngröße der supraleitenden MgB₂-Phase liegt im Bereich von 40 nm bis 100 nm. Die supraleitende Sprungtemperatur beträgt ca. 30 K bis 35 K. Das Massivmaterial weist eine kritische Stromdichte von ca. 10⁵ A/cm² bei 20 K und 1 Tesla auf und die Irreversibilitätslinie ist in Richtung höherer Felder verschoben, d.h. Hᵢᵣᵣ(T) ~ 0, 8 H_{c2}(T) im Gegensatz zu typischerweise Hᵢᵣᵣ (T) ~ 0,5 H_{c2}(T) für konventionelle, untexturierte, gesinterte Massivproben.

## Patentansprüche

1. Pulver auf MgB₂-Basis für die Herstellung von Supraleitern, **dadurch gekennzeichnet, dass** das Pulver ein mechanisch legiertes Pulver ist, dessen Pulverteilchen eine mittlere Teilchengröße von d < 250 µm und eine Substruktur, bestehend aus nanokristallinen Körnern in den Abmessungen < 100 nm, besitzen.

2. Pulver nach Anspruch 1, **dadurch gekennzeichnet, dass** im Kristallgitter der Pulverteilchen die chemischen Elemente H, Li, Na, Be, Mg, B, Ca, Sr, Ba, Al, Ga, In, Tl, C, Si, Ge, Sn, Pb, N, O, P, As, Sb, Bi, F, Cl, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os und/oder Ru enthalten sind.

3. Verfahren zur Herstellung eines Pulvers nach Anspruch 1, **dadurch gekennzeichnet, dass** eine Pulvermischung, bestehend aus Mg-Pulverteilchen und B-Pulverteilchen, bis zum Erreichen einer mittleren Teilchengröße von d < 250 µm und der Bildung einer Pulverteilchensubstruktur, bestehend aus nanokristallinen Körnern in den Abmessungen < 100 nm, mittels mechanischem Legieren zerkleinert werden.

4. Verfahren zur Herstellung eines Pulvers nach Anspruch 2, **dadurch gekennzeichnet, dass** Mg-Pulverteilchen und Bor-Pulverteilchen und ein Zusatz von bis zu 20 Atomprozent Pulverteilchen der chemischen Elemente Li, Na, Be, Mg, Ca, Sr, Ba, Al, Ga, In, Tl, C, Si, Ge, Sn, Pb, P, As, Sb, Bi, La, Ce, Pr, Nd, Pm, Sm, Eu, Gd, Tb, Dy, Ho, Er, Tm, Yb, Lu, Th, Ag, Cu, Au, Ni, Co, Pd, Pt, *Sc, Y,* Hf, Ti, Zr, Ta, V, Nb, Cr, Mo, Mn, Os und/oder Ru und/oder Pulverteilchen von Oxiden, Karbiden, Nitriden und/oder deren Mischkristalle bis zum Erreichen einer mittleren Teilchengröße von d < 250 µm und der Bildung einer Pulverteilchensubstruktur, bestehend aus nanokristallinen Körnern in den Abmessungen < 100 nm, mittels mechanischem Legieren zerkleinert werden.

5. Verfahren nach Anspruch 4 oder 5, **dadurch gekennzeichnet, dass** das mechanische Legieren unter Schutzgas oder in Luft und/oder unter Anwesenheit der gasförmigen Elemente H, N, O und/oder F durchgeführt wird.

6. Verfahren nach Anspruch 4, **dadurch gekennzeichnet, dass** das Pulver nach dem mechanischen Legieren im Falle des Vorliegens eines nur partiell legierten Pulvers einer Wärmebehandlung unterworfen wird.

7. Verfahren nach Anspruch 6, **dadurch gekennzeichnet, dass** für die Wärmebehandlung eine Temperatur gewählt wird, die mindestens 200 K unterhalb der typischen Reaktionstemperatur herkömmlicher Pulver dieser Art mit Pulverteilchen mit einer Größe im Mikrometermaßstab liegt.

8. Verfahren zur Anwendung eines Pulvers nach Anspruch 1 oder 2, **dadurch gekennzeichnet, dass** das Pulver in vollständig oder nur partiell legierter Ausführung zur Herstellung von hochtemperatursupraleitenden Massivkörpern verwendet wird, wobei das Pulver zu Massivkörpern verpresst und diese danach gesintert werden.

9. Verfahren nach Anspruch 8, **dadurch gekennzeichnet, dass** im Falle des Einsatzes eines nur partiell legierten Pulvers die Temperatur beim Verpressen mindestens 200 K unterhalb der typischen Reaktionstemperatur herkömmlicher Pulver dieser Art mit Pulverteilchen mit einer Größe im Mikrometermaßstab gewählt wird.

10. Verfahren nach Anspruch 8, **dadurch gekennzeichnet, dass** im Falle des Einsatzes eines nur partiell legierten Pulvers die im Herstellungsprozess übliche Wärmebehandlung zur Bildung der supraleitenden Phase bei einer Temperatur durchgeführt wird, die mindestens 200 K unterhalb der typischen Reaktionstemperatur herkömmlicher Pulver dieser Art mit Pulverteilchen mit einer Größe im Mikrometermaßstab liegt.

11. Verfahren nach den Ansprüche 7, 9 oder 10, **dadurch gekennzeichnet, dass** die Wärmehandlung beziehungsweise das Verpressen bei Temperaturen zwischen 300°C und 900°C durchgeführt werden.

12. Verwendung eines Pulvers nach Anspruch 1 oder 2, **dadurch gekennzeichnet, dass** das Pulver in vollständig oder nur partiell legierter Ausführung als Ausgangspulver für die Pulver-im-Rohr-Technologie zur Herstellung von hochtemperatursupraleitenden Drähten und Bändern verwendet wird.

13. Verwendung eines Pulvers nach Anspruch 1 oder 2, **dadurch gekennzeichnet, dass** das Pulver oder die daraus hergestellten Massivkörper als Ausgangs- oder Einsatzmaterial bei der Herstellung von Einkristallen, Drähten und Bändern oder als Targetmaterial bei der Abscheidung von Schichten eingesetzt werden.

## Claims

1. MgB₂-based powder for the production of superconductors, **characterized in that** the powder is a mechanically alloyed powder, the powder particles of which have a mean particle size of d < 250 µm and a substructure comprising nanocrystalline grains with dimensions of < 100 nm.

2. Powder according to Claim 1, **characterized in that** the chemical elements H, Li, Na, Be, Mg, B, Ca, Sr, Ba, Al, Ga, In, Tl, C, Si, Ge, Sn, Pb, N, O, P, As, Sb, Bi, F, Cl, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os and/or Ru are contained in the crystal lattice of the powder particles.

3. Method for producing a powder according to Claim 1, **characterized in that** a powder mixture, consisting of Mg powder particles and B powder particles, is comminuted by means of mechanical alloying until a mean particle size of d < 250 µm is achieved and a powder particle substructure comprising nanocrystalline grains with dimensions of < 100 nm is formed.

4. Method for producing a powder according to Claim 2, **characterized in that** Mg powder particles and boron powder particles and an addition of up to 20 atomic percent of powder particles of the chemical elements Li, Na, Be, Mg, Ca, Sr, Ba, Al, Ga, In, Tl, C, Si, Ge, Sn, Pb, P, As, Sb, Bi, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os and/or Ru and/or powder particles of oxides, carbides, nitrides and/or solid solutions thereof are comminuted by means of mechanical alloying until a mean particle size of d < 250 µm is achieved and a powder particle substructure comprising nanocrystalline grains with dimensions of < 100 nm is formed.

5. Method according to Claim 4 or 5, **characterized in that** the mechanical alloying is carried out under shielding gas or in air and/or in the presence of the gaseous elements H, N, O and/or F.

6. Method according to Claim 4, **characterized in that** after the mechanical alloying, the powder is subjected to a heat treatment if an only partially alloyed powder is present.

7. Method according to Claim 6, **characterized in that** a temperature which is at least 200 K below the typical reaction temperature for conventional powders of this type with powder particles of a size on the micrometer scale is selected for the heat treatment.

8. Method of using a powder according to Claim 1 or 2, **characterized in that** the powder, in completely or only partially alloyed form, is used to produce high-temperature superconducting solid bodies, the powder being pressed to form solid bodies and these solid bodies then being sintered.

9. Method according to Claim 8, **characterized in that** if an only partially alloyed powder is used, the pressing temperature is selected to be at least 200 K below the typical reaction temperature of conventional powders of this type comprising powder particles of a size on the micrometer scale.

10. Method according to Claim 8, **characterized in that** if an only partially alloyed powder is used, the heat treatment which is standard in the production process for forming the superconducting phase is carried out at a temperature which is at least 200 K below the typical reaction temperature of conventional powders of this type having power particles of a size on the micrometer scale.

11. Method according to Claims 7, 9 or 10, **characterized in that** the heat treatment and/or the pressing are carried out at temperatures between 300°C and 900°C.

12. Use of a powder according to Claim 1 or 2, **characterized in that** the powder is used in completely or only partially alloyed form as a starting powder for the powder-in-tube technique used to produce high-temperature superconducting wires and strips.

13. Use of a powder according to Claim 1 or 2, **characterized in that** the powder or the solid bodies produced therefrom are used as starting or feed material for the production of single crystals, wires and strips or as target material for the deposition of layers.

## Revendications

1. Poudre à base de MgB₂ pour la fabrication de supraconducteurs, **caractérisée en ce que** la poudre est une poudre alliée mécaniquement dont les particules ont une taille moyenne d < 250 µm et une sous-structure constituée de grains de nanocristaux d'une taille < 100 nm.

2. Poudre selon la revendication 1, **caractérisée en ce que** le réseau cristallin des particules de poudre contient les éléments chimiques suivants: H, Li, Na, Be, Mg, B, Ca, Sr, Ba, Al, Ga, In, Tl, C, Si, Ge, Sn, Pb, N, O, P, As, Sb, Bi, F, Cl, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os et/ou RU.

3. Procédé de fabrication d'une poudre selon la revendication 1, **caractérisé en ce que** l'on broie et on allie mécaniquement des particules de poudre de Mg et des particules de poudre de B qui forment un mélange de poudres, jusqu'à obtenir une granulométrie moyenne d < 250 µm et la formation d'une sous-structure de particules de poudre constituée de grains de nanocristaux d'une taille < 100 nm.

4. Procédé de fabrication d'une poudre selon la revendication 2, **caractérisé en ce que** l'on broie et on allie mécaniquement des particules de poudre de Mg, des particules de poudre de bore et une addition de jusque 20 pour cent atomiques de particules de poudre des éléments chimiques Li, Na, Be, Mg, Ca, Sr, Ba, Al, Ga, In, Tl, C, Si, Ge, Sn, Pb, P, As, Sb, Bi, La, Ce, Pr, Nd, Pm, Sm, Eu, Gd, Tb, Dy, Ho, Er, Tm, Yb, Lu, Th, Ag, Cu, Au, Ni, Co, Pd, Pt, Sc, Y, Hf, Ti, Zr, Ta, V, Nb, Cr, Mo, Mn, Os, et/ou RU et/ou des particules de poudre d'oxydes, de carbures, de nitrures et/ou leurs cristaux mixtes, jusqu'à l'obtention d'une granulométrie moyenne d < 250 µm et la formation d'une sous-structure de particules de poudre constituée de grains de nanocristaux d'une taille < 100 nm.

5. Procédé selon les revendications 4 ou 5, **caractérisé en ce qu'**on réalise l'alliage mécanique dans un gaz de protection ou dans l'air et/ou en présence des éléments gazeux H, N, O et/ou F.

6. Procédé selon la revendication 4, **caractérisé en ce que** la poudre subit un traitement thermique lorsqu'elle n'est que partiellement alliée.

7. Procédé selon la revendication 6, **caractérisé en ce que** la température de traitement thermique sélectionnée est d'au moins 200 K plus basse que la température de réaction typique de poudres habituelles de ce type de granulométrie de l'ordre du micromètre.

8. Procédé d'utilisation d'une poudre selon les revendications 1 ou 2, **caractérisé en ce qu'**on utilise la poudre totalement ou seulement partiellement alliée pour fabriquer des corps massifs supraconducteurs à haute température, la poudre étant comprimée pour obtenir des corps massifs qui sont ensuite frittés.

9. Procédé selon la revendication 8, **caractérisé en ce que** lorsqu'on utilise une poudre qui n'est que partiellement alliée, on sélectionne une température de compression d'au moins 200 K plus basse que la température typique de réaction de poudres habituelles de ce type de granulométrie de l'ordre du micromètre.

10. Procédé selon la revendication 8, **caractérisé en ce que** lorsqu'on utilise une poudre qui n'est que partiellement alliée, on réalise le traitement thermique habituel lors le l'opération de fabrication et qui sert à former la phase supraconductrice à une température d'au moins 200 K plus basse que la température typique de réaction de poudres habituelles de ce type qui présentent des particules de taille de l'ordre du micromètre.

11. Procédé selon les revendications 7, 9 ou 10, **caractérisé en ce qu'**on réalise le traitement thermique et la compression à des températures comprises entre 300°C et 900°C.

12. Utilisation d'une poudre selon les revendications 1 ou 2, **caractérisée en ce que** l'on utilise la poudre totalement ou seulement partiellement alliée comme poudre de départ pour la technique des poudres en tube pour fabriquer des fils et des rubans supraconducteurs à haute température.

13. Utilisation d'une poudre selon les revendications 1 ou 2, **caractérisée en ce qu'**on utilise la poudre ou les corps massifs fabriqués à partir de celle-ci comme matériaux de départ ou matériaux de charge en fabrication de monocristaux, de fils et de rubans ou comme matériaux de cibles pour le dépôt de couches.
